Europäisches Patentamt

European Patent Office

Office européen des brevets

(19)

(11) **EP 0 448 071 B1**

(12) **EUROPÄISCHE PATENTSCHRIFT**

(45) Veröffentlichungstag und Bekanntmachung des Hinweises auf die Patenterteilung:
28.02.1996 Patentblatt 1996/09

(51) Int Cl.6: **H03G 3/20**

(21) Anmeldenummer: **91104325.5**

(22) Anmeldetag: **20.03.1991**

(54) **Regeleinrichtung für Funkempfänger**

Controlling system for radio receiver

Système de commande pour radio-récepteur

(84) Benannte Vertragsstaaten:
**DE FR GB IT**

(30) Priorität: **21.03.1990 DE 4009140**

(43) Veröffentlichungstag der Anmeldung:
**25.09.1991 Patentblatt 1991/39**

(73) Patentinhaber: **C. Plath GmbH
Nautisch-Elektronische Technik
D-20097 Hamburg (DE)**

(72) Erfinder:
• **Fast, Peter
W-2000 Hamburg 54 (DE)**

• **Harders, Bodo
W-2059 Müssen (DE)**

(74) Vertreter: **VOSSIUS & PARTNER
Postfach 86 07 67
D-81634 München (DE)**

(56) Entgegenhaltungen:
**EP-A- 0 272 161          DE-A- 3 216 707**

• **MEINKE, GUNDLACH 'Taschenbuch der Hochfrequenztechnik', 1986, SPRINGER-VERLAG, BERLIN/HEIDELBERG**
• **ELEKTRONIK. Bd. 37, Nr. 5, 4. März 1988, MUNCHEN DE, Seiten 94 - 100; J. WYNNE: 'Programmierbarer Verstärker mit DAU und OPV'**

EP 0 448 071 B1

**Beschreibung**

Die Erfindung betrifft eine digitale Regeleinrichtung für elektrische Signale, insbesondere für das Zwischenfrequenz (ZF)-Signal in einem Funkempfänger gemäß dem Oberbegriff des Anspruchs 1 sowie eine mehrere derartige in Reihe geschaltete Regeleinrichtungen aufweisende Schaltung.

Eine wichtige Eigenschaft eines modernen Aufklärungsempfängers ist sein Großsignalverhalten, das hauptsächlich durch die Angabe des Dynamikumfanges sowie des Intermodulationsverhaltens beschrieben wird. Nach Rudolf Grabau "Funküberwachung und Elektronische Kampfführung" (1986), S. 192 (D1) besitzen einfache Warnempfänger beispielsweise einen Dynamikbereich von 40-70 dB, durchschnittliche kommerzielle Empfänger 80-100 dB und Aufklärungsempfänger einen Dynamikbereich bis zu 140 dB.

Die einfachste Möglichkeit, einen sehr großen Dynamikumfang zu erreichen, besteht darin, große Empfängereingangssignale zu bedämpfen; dadurch tritt jedoch eine Empfindlichkeitsverminderung ein, die in den meisten Fällen nicht akzeptiert werden kann. Üblicherweise wird daher eine Kombination aus Eingangsabschwächung und Regelung des Pegels im ZF-Verstärker gewählt, wobei auf den ZF-Verstärker der größere Regelumfang von beispielsweise 100-120 dB und auf den Eingangsabschwächer eine Regelung von 10-40 dB entfällt. Diese Regelung wird im allgemeinen als Rückwärtsregelung ausgeführt, wobei als Regelkriterium der ZF-Ausgangspegel dient (vgl. Meinke/Gundlach "Taschenbuch der Hochfrequenztechnik" (1986), Q 34 (D2)). Dazu wird die ZF-Spannung gleichgerichtet und durch ein Siebglied von der ZF- und Modulationsfrequenz getrennt. Dieses Siebglied bildet die Regelzeitkonstante, die die Regelgeschwindigkeit bestimmt. Die so gewonnene Gleichspannung wird in einem Regelverstärker verstärkt und als Regelspannung dem ZF-Verstärker bzw. dem Eingangsabschwächer als Steuerspannung zugeführt. Bei großem Regelumfang werden mehrere Verstärkerstufen hintereinandergeschaltet.

Neben dieser analogen Regelung ist auch eine digitale Regelung bekannt (vgl. DE-A-21 61 657 und der DE-A- 21 64 846), bei der die Regelgleichspannung in einem Fensterkomparator mit zwei Schwellenspannungen verglichen wird. Dabei werden Steuersignale für einen vor-/rückwärts-zählenden Binärzähler erzeugt, dessen Zählerstand zu einem Digital/Analog (D/A)-Wandler gelangt, der daraus eine analoge Spannung zur Regelung der ZF-Verstärker bzw. des Eingangsabschwächers gewinnt. Diese digitale Regeleinrichtung stellt eine Kombination aus analoger Verstärkungsänderung mit digitaler Steuerung dar, wobei üblicherweise steuerbare Halbleiter wie Dioden, Transistoren und Operationsverstärker eingesetzt werden, die aufgrund ihrer thermischen Empfindlichkeit und Toleranzen in der Linearität für mehrkanalige Anwendungen, bei denen ein hoher Gleichlauf erforderlich ist, zu einem erheblichen Selektionsaufwand führen.

In D2 (Q 36) wird ein geschalteter ZF-Verstärker angegeben, der aus einer Kette von gleichartigen Verstärkerstufen besteht, dessen Verstärkung binär gestaffelt umgeschaltet werden kann. Auch diese digitale ZF-Regelung erhält die Steuersignale über einen Binärzähler. Dieser Regelkreis wirkt als integrierender Regler, da der Regelkreis erst dann zur Ruhe kommt, wenn die gleichgerichtete ZF-Ausgangsspannung ihren Sollwert erreicht hat. Die Regelgeschwindigkeit wird durch die Taktfrequenz des Binärzählers bestimmt.

Demgegenüber liegt der Erfindung die Aufgabe zugrunde, ein elektrisches Signal über einen großen Dynamikbereich mit im wesentlichen konstanter Amplitude sehr schnell zu regeln.

Eine Regelschaltung gemäß dem Oberbegriff von Anspruch 1 ist aus EP-A-0 272 161 bekannt.

Erfindungsgemäß wird die oben genannte Aufgabe mit den im Patentanspruch 1 angegebenen Merkmalen gelöst.

Bei dieser Lösung geht die Erfindung von dem Grundgedanken aus, daß aus dem Eingangssignal eine digitale Größe gewonnen und dann invertiert wird, und damit das als Referenzsignal dienende Eingangssignal so geregelt wird, daß auch bei starker Änderung der Größe des Eingangssignals das Ausgangssignal im wesentlichen konstant bleibt.

Die Vorteile der erfindungsgemäßen Regeleinrichtung sind:

- hohe Regelgeschwindigkeit, die praktisch nur durch die Umsetzdauer der Analog/Digital(A/D)-Wandler und der D/A-Wandler bestimmt wird,
- großer Regelumfang bei entsprechender Kaskadierung der Einzelstufen,
- durch Einsatz von Zwischenspeichern kann die Regeleinrichtung über einen Mikroprozessor signaloptimiert in der Zeit gesteuert werden,
- in Verbindung mit Selektionseinrichtungen können Über-steuerungseffekte, wie bei herkömmlich geregelten ZF-Verstärkern, nicht auftreten, da der Regelumfang auf die Einzelstufen automatisch verteilt wird.

Die Erfindung wird nachstehend mit Bezug auf die anliegenden Zeichnungen näher erläutert. Es zeigen:

Fig. 1    ein Prinzipschaltbild einer Stufe der erfindungsgemäßen Regeleinrichtung,
Fig. 2    ein Prinzipschaltbild einer Stufe der erfindungsgemäßen Regeleinrichtung für ein Wechselspannungseingangssignal,
Fig. 3    ein Prinzipschaltbild der Komparatoren in einem A/D-Wandler nach dem Parallelverfahren (Flash-Converter) und die Komparatorzustände in Abhängigkeit von der Eingangsspannung,

Fig. 4 ein normiertes $U_a/U_e$-Diagramm bei einer Schaltung mit einem 8-Bit-D/A-Wandler,

Fig. 5 eine logarithmische Darstellung des normierten $U_a/U_e$-Diagramms einer kaskadierten Schaltung mit 8-Bit-D/A-Wandlern,

Fig. 6 ein normiertes $U_a/U_e$-Diagramm bei einer Schaltung mit 4-Bit-D/A-Wandler nach einer anderen Ausführungsform

       a) bei einer Stufe,
       b) bei einer kaskadierten Schaltung mit Verstärkung, und

Fig. 7 ein Prinzipschaltbild eines Mehrkanalempfängers mit kaskadierten Regelstufen und Mikroprozessorsteuerung.

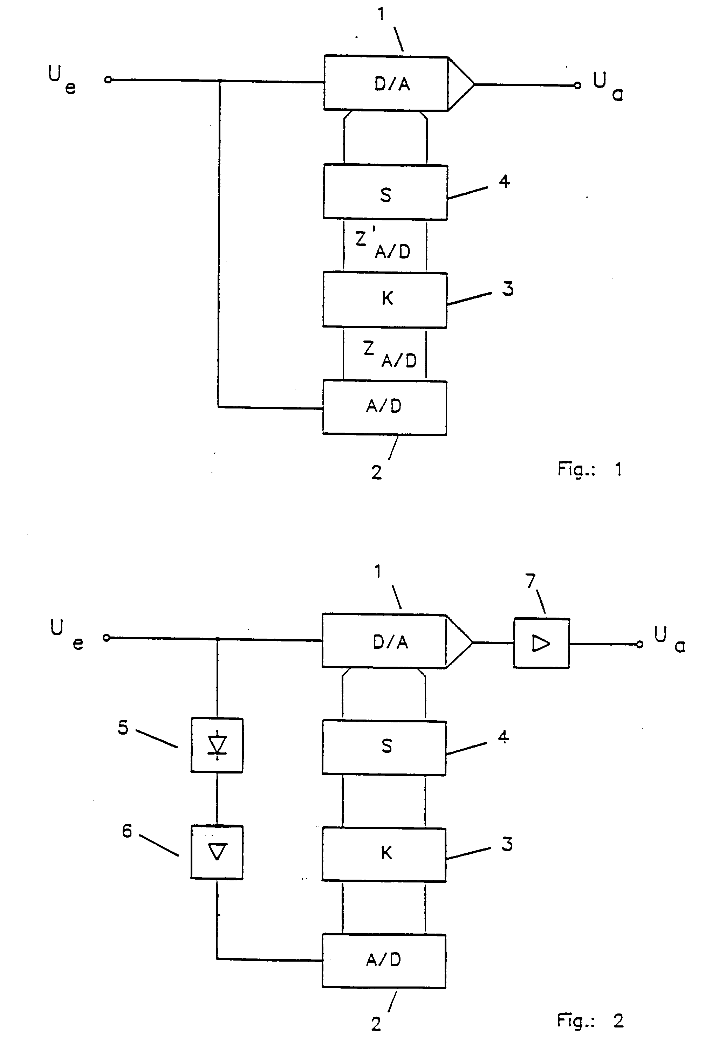

Gemäß Fig. 1 wird die zu regelnde Spannung $U_e$ sowohl an einen multiplizierenden D/A-Wandler 1 als Referenzsignal $U_{REF}$ als auch an einen A/D-Wandler 2 gelegt, der die Spannung in einen digitalen Wert umsetzt. Dieser Wert wird in einer Kodierschaltung 3 und gegebenenfalls über einen Zwischenspeicher 4 auf die Steuereingänge des D/A-Wandlers 1 geschaltet. Der D/A-Wandler multipliziert die Eingangsspannung mit dem digitalen Wert und liefert eine Ausgangsspannung $U_a$ (vgl. Tietze/Schenk "Halbleiter-Schaltungs-Technik" (1978), 24,1.3 (D3)) :

$$U_a = - \frac{U_{REF}}{2^n} \cdot \frac{R_N}{R} \cdot Z_{D/A},$$

wobei beispielsweise bei einem 8-Bit-Wandler der Faktor $2^n = 256$ beträgt, bei einem geschalteten Widerstandsnetzwerk das Widerstandsverhältnis $R_N/R = 1$ gesetzt werden kann und $Z_{D/A}$ der digitale Wert bedeutet, der die Werte (bei einem 8-Bit-Wandler) von 0 bis 255 annehmen kann.

Der A/D-Wandler 2 setzt die zu regelnde Eingangsspannung $U_e$ in einen digitalen Wert um:

$$Z_{A/D} = U_e/U_{LSB},$$

wobei $U_{LSB}$ die kleinste Spannung ist, die aufgelöst werden kann, und $Z_{A/D}$ den Bereich 0 bis $(2^n-1)$ umfaßt mit n als Anzahl der Bits. Dieser digitale Wert $Z_{A/D}$ wird umkodiert in $Z'_{A/D}$ und an die Steuereingänge des D/A-Wandlers(gegebenenfalls über einen Zwischenspeicher) gelegt. Ersetzt man die Referenzspannung $U_{REF}$ durch $U_e$, so erhält man eine Ausgangsspannung am Ausgang des D/A-Wandlers nach folgender Funktion:

$$U_a = - \frac{U_e}{2^n} \cdot Z'_{A/D} \quad \left( \frac{R_N}{R} = 1 \right)$$

Die auf diese Weise erzeugte, von der Kodierung der D/A-Wandler-Daten abhängige Spannung kann einer gleichartigen Schaltungseinrichtung als Eingangsspannung dienen. In dieser wird auf gleiche Art und Weise eine Ausgangsspannung gewonnen. Derartige Schaltungen können beliebig kaskadiert werden.

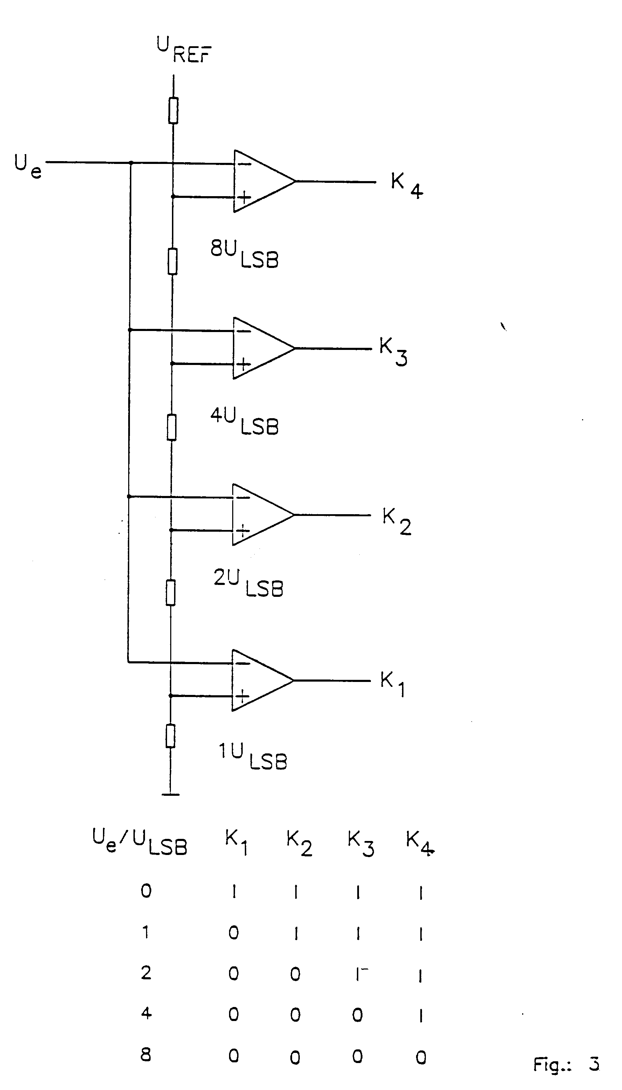

Gemäß Fig. 2 wird eine Wechselspannung $U_e$ einerseits an den Referenzeingang eines D/A-Wandlers 1 und andererseits über einen Gleichrichter 5 und einen Verstärker 6 an den A/D-Wandler 2 gelegt. Der A/D-Wandler ist gemäß Fig. 3 beispielsweise nach dem Parallelverfahren realisiert. Die Referenzausgänge der Komparatoren K1 bis K4 sind derart gestaffelt, daß sich jeweils bei Verdopplung der Eingangsspannung die Komparatorzustände ändern.

Die Komparatorausgänge dienen einem 8-Bit-D/A-Wandler als digitale Steuerinformation. Die Kodierung dieser Steuerinformation besteht darin, daß die Komparatorausgänge nur an die 4 höherwertigen Steuereingänge des D/A-Wandlers in der Reihenfolge ihrer Wertigkeiten vertauscht (ohne Umsetzung auf Dualzahlen) angeschlossen werden. Die 4 niedrigsten Steuereingänge des D/A-Wandlers liegen dabei fest auf höchstem Potential.

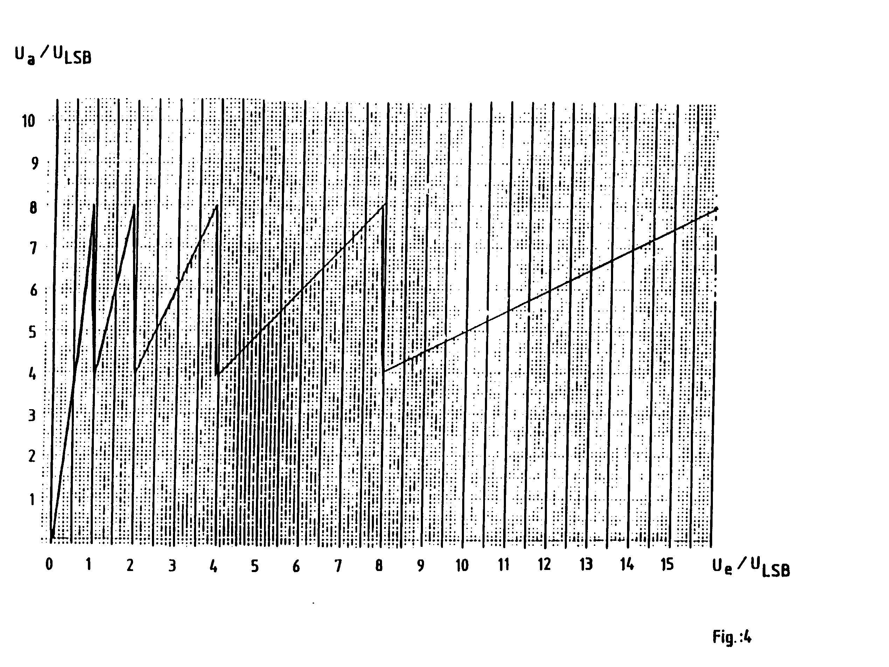

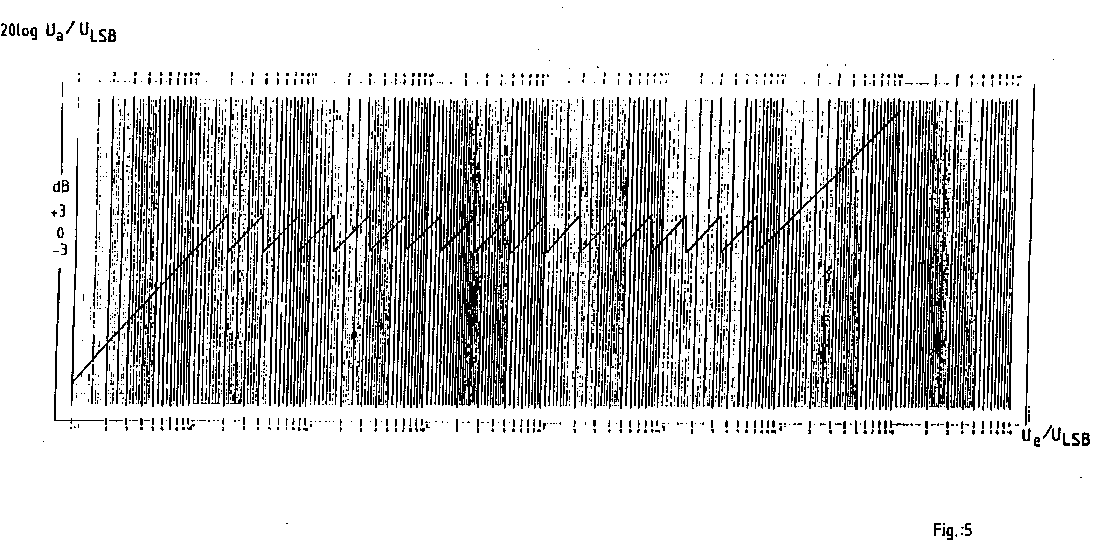

Aus Fig. 4 ist ersichtlich, wie sich die Ausgangsspannung des D/A-Wandlers bei derartiger Beschaltung verhält, wenn sich die Eingangsspannung ändert. Bei einer Eingangsspannung unterhalb 1 $U_{LSB}$ steigt die Ausgangsspannung zunächst linear mit $U_e$ an (der D/A-Wandler hat dann die Steuerdaten 11111111) und springt bei Erreichen von 1 $U_{LSB}$ auf den halben Wert (Steuerdaten 11111110). Dann steigt die Ausgangsspannung wieder linear mit $U_e$ an, bis $U_e$ den doppelten Wert erreicht hat (Steuerdaten 11111100), und sinkt daraufhin wieder auf die Hälfte usw. Bei jeder Verdopplung der Eingangsspannung tritt ein Sprung auf. Werden z.B. vier derartige Schaltungen mit einem zusätzlichen Verstärker 7 nach Fig. 2 kaskadiert, so läßt sich die Eingangsspannung um 96 dB variieren, wobei die Ausgangsspannung am Ende der Kaskade lediglich die 6 dB-Sprünge aufweist (Fig. 5). Diese verbleibende Welligkeit läßt sich - falls erforderlich - mit herkömmlichen Regelschaltungen leicht ausregeln.

In einer anderen Ausführungsform der Erfindung analog Fig. 2 und 3 werden die Daten des A/D-Wandlers 2 in Dualzahlen umkodiert und mit vertauschter Reihenfolge ihrer Wertigkeiten an einen D/A-Wandler angeschlossen. Wie oben ausgeführt, liefert der A/D-Wandler die digitalen Daten

$$Z_{A/D} = \frac{U_e}{U_{LSB}}$$

die im Falle eines 4-Bit-Wandlers die Werte von 0 bis 15 annehmen können. Durch Invertieren der Reihenfolge ergibt sich der Wertebereich

$$Z'_{A/D} = 15 - Z_{A/D} = 15 - \frac{U_e}{U_{LSB}}$$

Der D/A-Wandler 1, dessen vier niedrigste Steuereingänge wieder fest auf höchstem Potential liegen, wird mit diesem digitalen Wert $Z'_{A/D}$ gesteuert und liefert die Ausgangsspannung:

$$U_a = -\frac{U_e}{16} \cdot Z'_{A/D}$$

$$= -\frac{U_e}{16} \cdot (15 - \frac{U_e}{U_{LSB}})$$

oder normiert

$$\frac{U_a}{U_{LSB}} = -\frac{15}{16} \cdot \frac{U_e}{U_{LSB}} + \frac{1}{16}\left(\frac{U_e}{U_{LSB}}\right)^2$$

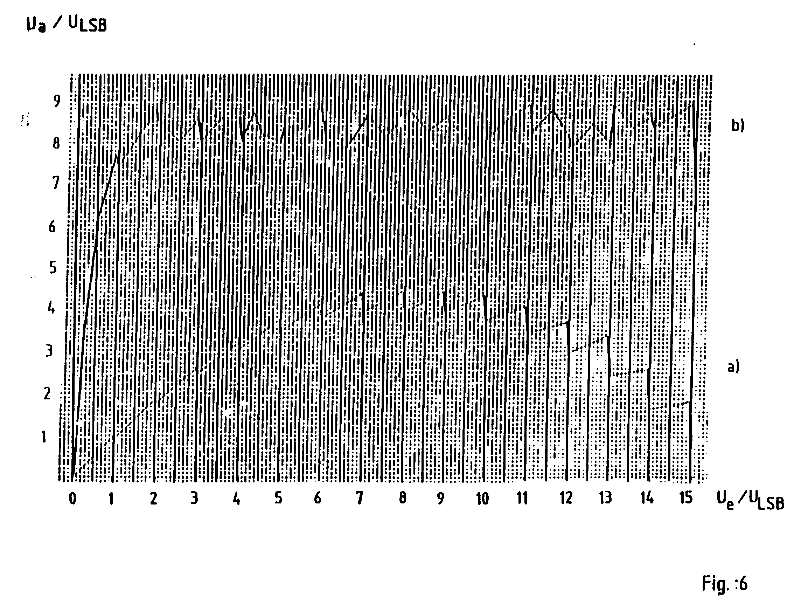

In Fig. 6a ist diese Funktion dargestellt. Der Verlauf der Ausgangsspannung wird durch den linearen und den quadratischen Anteil bestimmt.

Bei Kaskadierung derartiger Stufen mit zusätzlicher Verstärkung um den Faktor 2 ergibt sich der in Fig. 6b dargestellte Verlauf der Ausgangsspannung am Ende der Kaskade. Im Gegensatz zum erstgenannten Ausführungsbeispiel ist hier die Welligkeit erheblich geringer, jedoch beträgt der Regelumfang nur 24 dB. Dieser kann aber durch die Verwendung von D/A-bzw. A/D-Wandlern mit größerer Auflösung erhöht werden.

Der Einsatz der erfindungsgemäßen Regeleinrichtung in einem mehrkanaligen Empfänger, wie z.B. Peilempfänger nach dem Watson-Watt-Verfahren, erweist sich wegen der Unempfindlichgegenüber Übersteuerungseffekten, die erhebliche Peilfehler zur Folge haben können, als besonders vorteilhaft. In der erfindungsgemäßen Anordnung für Watson-Watt-Peilempfänger sind alle A/D-Wandler-Ausgänge stufenweise parallel geschaltet, so daß automatisch der Kanal mit der stärksten Signalamplitude den Regelzustand bestimmt und damit die gleichzeitige Regelung aller Stufen gewährleistet ist.

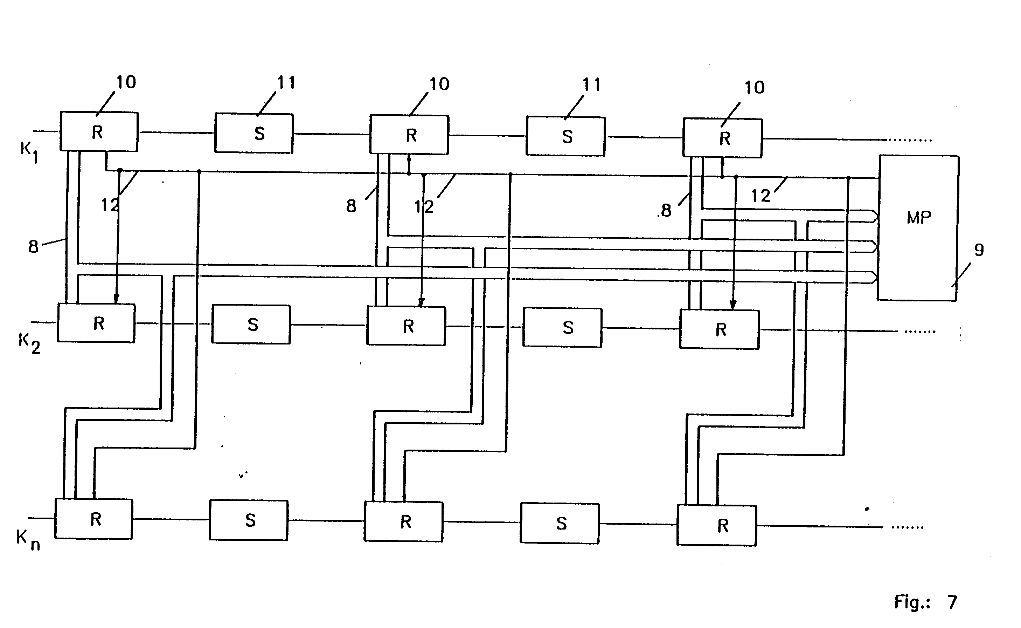

In einem mehrkanaligen Empfänger nach Fig. 7 mit den Kanälen K1 bis Kn, den kaskadierten Regelstufen 10 und den verteilten Selektionsmitteln 11 bietet es sich an, die A/D-Wandler-Daten über einen Parallelport 8 an eine Mikroprozessorsteuerung 9 zu schalten. Über den Parallelport erhält der Mikroprozessor eine genaue Statusinformation über den Regelzustand des Empfängers und kann bei Bedarf die Regelstufen signaloptimiert in der Zeit steuern (verschiedene Haltezeitkonstanten durch Zeitsteuersignal 12). Zusätzlich kann die Empfangsfeldstärke genau bestimmt und ausgewertet werden.

## Patentansprüche

1. Digitale Regeleinrichtung für analoge elektrische Signale, insbesondere für das ZF-Signal in einem Funkempfänger, mit

   a) einem digital steuerbaren Signalumformer (1) zwischen dem analogen Eingangssignal ($U_e$) und dem analogen Ausgangssignal ($U_a$) und mit
   b) einem A/D-Wandler (2) zum Erzeugen des digitalen Eingangssignals (Z, Z') für den Signalumformer (1),
   c) wobei der Signalumformer ein multiplizierender D/A-Wandler (1) ist, dem das analoge Eingangssignal ($U_e$) als Referenzspannung zugeführt wird,
   d) das analoge Eingangssignal ($U_e$) auch dem A/D-Wandler (2) zugeführt wird,
   e) zwischen dem A/D-Wandler (2) und dem D/A-Wandler (1) eine Kodierschaltung (3) zur konvertierung des digitalen Eingangssignales für den D/A-Wandler vorgesehen ist.

   **dadurch gekennzeichnet,**
   daß das Ausgangssignal ($U_a$) des D/A-Wandlers (1) so geregelt wird, daß es eine im wesentlichen konstante Amplitude aufweist.

**2.** Regeleinrichtung nach Anspruch 1, **dadurch gekennzeichnet,** daß die Kodierschaltung (3) die Reihenfolge der Werte des digitalisierten Eingangssignals in ihrer Wertigkeit vertauscht.

**3.** Regeleinrichtung nach Anspruch 1 oder 2, **dadurch gekennzeichnet,** daß zwischen der Kodierschaltung (3) und den D/A-Wandler (1) ein Zwischenspeicher (4) vorgesehen ist.

**4.** Regeleinrichtung nach einem der Ansprüche 1 bis 3, **dadurch gekennzeichnet,** daß der AD-Wandler (2) nach dem Parallelverfahren arbeitet, wobei die Referenzausgänge von Komparatoren (K1 - K4) als digitale Steuerinformation für den D/A-Wandler (1) dienen und die Komparatoren derart gestaffelt sind, daß mit steigender Intensität des Eingangssignals periodisch eine sprunghafte Reduzierung der Intensität des Ausgangssignals bewirkt wird.

**5.** Regeleinrichtung nach einem der Ansprüche 1 bis 4, **dadurch gekennzeichnet,** daß das Eingangssignal ($U_e$) in Form einer Wechselspannung nach Gleichrichtung in einem Gleichrichter (5) und Verstärkung in einem Verstärker (6) dem A/D-Wandler (2) zugeführt wird.

**6.** Regeleinrichtung nach einem der Ansprüche 1 bis 5, **dadurch gekennzeichnet,** daß nach dem D/A-Wandler (1) ein Verstärker (7) vorgesehen ist.

**7.** Regeleinrichtung nach einem der Ansprüche 1 bis 6, **dadurch gekennzeichnet,** daß die A/D-Wandlerdaten an eine Mikroprozessorsteuerung (9) geschaltet sind.

**8.** Regeleinrichtung nach einem der Ansprüche 1 bis 7, **dadurch gekennzeichnet,** daß alle A/D-Wandlerausgänge stufenweise parallel geschaltet sind.

**9.** Regeleinrichtung nach einem der Ansprüche 1 bis 8, dadurch gekennzeichnet, daß das Ausgangssignal ($U_a$) des D/A-Wandlers (1) nahezu verzögerungsfrei geregelt wird.

**10.** Schaltung, **gekennzeichnet** durch zwei oder mehr gleichartige in Reihe geschaltete Regeleinrichtungen nach einem der Ansprüche 1 bis 9.

## Claims

**1.** A digital control unit for electric analogue signals, in particular for the intermediate-frequency signal in a radio receiver, comprising:

a) a digitally controlled transducer (1) between the analogue input signal ($U_e$) and the analogue output signal ($U_a$), and
b) an analogue-digital converter (2) for producing the digital input signal (Z, Z') for the transducer (1), wherein
c) the transducer is a multiplying digital-analogue converter (1) to which the analogue input signal ($U_e$) is supplied as reference voltage,
d) the analogue input signal ($U_e$) is also supplied to the analogue-digital converter (2),
e) an encoder (3) is provided between the analogue-digital converter (2) and the digital-analogue converter (1) for converting the digital input signal for the digital-analogue converter,

**characterised in that**
the output signal ($U_a$) of the digital-analogue converter (1) is controlled such that it has an essentially constant amplitude.

**2.** The control unit according to claim 1, **characterised in that** the coding circuit (3) reverses the order of the values of the digitised input signal.

**3.** The control unit according to claim 1 or 2, **characterised in that** an intermediate memory (4) is provided between the coding circuit (3) and the digital-analogue converter (1).

**4.** The control unit according to any of claims 1 to 3, **characterised in that** the analogue-digital converter (2) is a parallel-type converter, the reference outputs of comparators ($K_1$-$K_4$) serving as digital control data for the digital-analogue converter (1) and the comparators being graded such that the intensity of the output signal is periodically and abruptly reduced while the intensity of the input signal increases.

5. The control unit according to any of claims 1 to 4, **characterised in that** the input signal (U$_e$) is supplied to the analogue-digital converter (2) in the form of a.c. voltage after being rectified in a rectifier (5) and amplified in an amplifier (6).

6. The control unit according to any of claims 1 to 5, **characterised in that** an amplifier (7) is provided downstream the digital-analogue converter (1).

7. The control unit according to any of claims 1 to 6, **characterised in that** the analogue-digital converter data are connected to a microprocessor control (9).

8. The control unit according to any of claims 1 to 7, **characterised in that** all analogue-digital converter outputs are gradually connected in parallel.

9. The control unit according to any of claims 1 to 8, **characterised in that** the output signal (U$_a$) of the digital-analogue converter (1) is controlled almost instantaneously.

10. A circuitry **characterised by** two or more similar control units according to any of claims 1 to 9 which are connected in series.


## Revendications

1. Dispositif de régulation numérique pour des signaux électriques analogiques, notamment pour le signal à fréquence intermédiaire dans un récepteur radio, comprenant:

   a) un traducteur de signal (1) commandé numériquement placé entre l'entrée (U$_e$) de signal analogique et la sortie (U$_a$) de signal analogique,
   b) un convertisseur A/N (2) pour produire le signal d'entrée (Z, Z') numérique destiné au traducteur de signal (1),
   c) le traducteur de signal étant un convertisseur N/A (1) multiplicateur auquel le signal d'entrée (U$_e$) analogique est appliqué en tant que tension de référence,
   d) le signal d'entrée (U$_e$) analogique étant appliqué également au convertisseur A/N (2) et
   e) un circuit codeur (3) étant prévu entre le convertisseur A/N (2) et le convertisseur N/A (1) aux fins de convertir le signal d'entrée numérique pour le convertisseur N/A,

   caractérisé par le fait que le signal de sortie (U$_a$) du convertisseur N/A (1) est régulé de manière telle que celui-ci ait une amplitude sensiblement constante.

2. Dispositif de régulation selon la revendication 1, caractérisé par le fait que le circuit codeur (3) permute l'ordre des valeurs du signal d'entrée numérisé sur le plan de leur valence.

3. Dispositif de régulation selon la revendication 1 ou la revendication 2, caractérisé par le fait qu'il est prévu une mémoire intermédiaire (4) entre le circuit codeur (3) et le convertisseur N/A (1).

4. Dispositif de régulation selon l'une des revendications 1 à 3, caractérisé par le fait que le convertisseur A/N (2) travaille selon le procédé parallèle, les sorties de référence de comparateurs (K1 à K4) servant d'information numérique de commande pour le convertisseur N/A (1) et les comparateurs étant échelonnés de manière telle qu'il se produise périodiquement un abaissement par paliers de l'intensité du signal de sortie, au fur et à mesure que l'intensité du signal d'entrée augmente.

5. Dispositif de régulation selon l'une des revendications 1 à 4, caractérisé par le fait que le signal d'entrée (U$_e$) qui se présente sous la forme d'une tension alternative est amené au convertisseur A/N (2) après redressement dans un redresseur (5) et amplification dans un amplificateur (6).

6. Dispositif de régulation selon l'une des revendications 1 à 5, caractérisé par le fait qu'il est prévu un amplificateur (7) derrière le convertisseur N/A (1).

7. Dispositif de régulation selon l'une des revendications 1 à 6, caractérisé par le fait que les données du convertisseur A/N sont envoyées à une commande (9) à microprocesseur.

8. Dispositif de régulation selon l'une des revendications 1 à 7, caractérisé par le fait que toutes les sorties du convertisseur A/N sont connectées en parallèle en paliers.

9. Dispositif de régulation selon l'une des revendications 1 à 8, caractérisé par le fait que le signal de sortie ($U_a$) du convertisseur N/A (1) est régulé pratiquement sans retard.

10. Circuit, caractérisé par deux dispositifs de régulation ou plus, de même type, selon les revendications 1 à 9, connectés en série.

Fig.: 1

Fig.: 2

$U_{REF}$

$U_e$

$K_4$

$8U_{LSB}$

$K_3$

$4U_{LSB}$

$K_2$

$2U_{LSB}$

$K_1$

$1U_{LSB}$

| $U_e/U_{LSB}$ | $K_1$ | $K_2$ | $K_3$ | $K_4$ |
|---|---|---|---|---|
| 0 | I | I | I | I |
| 1 | 0 | I | I | I |
| 2 | 0 | 0 | I | I |
| 4 | 0 | 0 | 0 | I |
| 8 | 0 | 0 | 0 | 0 |

Fig.: 3

Fig.:4

20log $U_a / U_{LSB}$

dB
+3
0
−3

$U_e / U_{LSB}$

EP 0 448 071 B1

Fig.:5

Fig. :6

EP 0 448 071 B1

Fig.: 7